# DEMANDE DE BREVET EUROPEEN

(11) **EP 2 747 155 A1**
(43) Date de publication de la demande: **25.06.2014**
(21) Numéro de dépôt: 13198143.3
(22) Date de dépôt: 18.12.2013
(51) Int. Cl.: H01L 33/00, H01L 33/28

(54) **Procédé de fabrication d'une structure, notamment de type MIS, en particulier pour diode électroluminescente**

(30) Priorité: 19.12.2012 FR 1262305
(71) Demandeur: Commissariat à l'Énergie Atomique et aux Énergies Alternatives, 75015 Paris (FR)
(72) Inventeur: Robin, Ivan-Christophe, 38000 Grenoble (FR)
(74) Mandataire: Audier, Philippe André

(57) **Abrégé**

L'invention concerne un procédé de fabrication d'une structure, notamment d'une structure de type Métal-Isolant-Semi-conducteur ou MIS, en particulier pour une diode électroluminescente.

Plus précisément, l'invention a trait à un procédé de fabrication d'une structure comprenant un substrat semi-conducteur en un oxyde d'au moins un métal, semi-conducteur, de type n, une première face du substrat semi-conducteur en ZnO étant revêtue d'une couche en un matériau électriquement isolant, et la couche en un matériau électriquement isolant étant revêtue d'au moins une couche en un matériau électriquement conducteur tel qu'un métal.

L'invention trouve notamment son application dans la réalisation de diodes électroluminescentes DELs ou de transistors à effet de champ (« *Field Effect Transistor* » ou « *FET* » en langue anglaise).

## Description

### DOMAINE TECHNIQUE

L'invention concerne un procédé de fabrication d'une structure, notamment d'une structure de type Métal-Isolant-Semi-conducteur ou MIS, en particulier pour une diode électroluminescente.

Plus précisément, l'invention a trait à un procédé de fabrication d'une structure comprenant un substrat semi-conducteur en un oxyde d'au moins un métal, semi-conducteur, de type n, une première face du substrat semi-conducteur en ZnO étant revêtue d'une couche en un matériau électriquement isolant, et la couche en un matériau électriquement isolant étant revêtue d'au moins une couche en un matériau électriquement conducteur tel qu'un métal.

L'invention trouve notamment son application dans la réalisation de diodes électroluminescentes DELs.

De nombreux dispositifs lumineux sont basés sur de telles diodes, tels que des écrans, des projecteurs, des murs d'images, etc.

Ces diodes peuvent également être utilisées dans des dispositifs de désinfection de l'eau par irradiation avec de la lumière ultraviolette.

L'invention trouve aussi son application dans la réalisation de transistors à effet de champ (« *Field Effect Transistor* » ou « *FET* » en langue anglaise).

### ÉTAT DE LA TECHNIQUE ANTÉRIEURE

Une diode électroluminescente ou DEL (« *Light Emitting Diode* » ou « LED » en langue anglaise) est un composant électronique capable d'émettre de la lumière lorsqu'il est parcouru par un courant électrique. Il existe des DELs qui émettent une lumière blanche, des DELs qui émettent une lumière de couleur, ou bien une lumière infrarouge, ou encore une lumière ultraviolette (UV).

Plus exactement, une diode électroluminescente est une jonction p-n dans un matériau semi-conducteur. Lorsque cette jonction p-n est polarisée en sens direct, la recombinaison des électrons et des trous dans le matériau semi-conducteur de la diode provoque l'émission de photons.

La plupart des recombinaisons sont radiatives, et la face émettrice de la DEL se situe du côté de la zone P car c'est la zone la plus radiative.

Les semi-conducteurs à grands gaps (à larges bandes interdites) II-V à base de nitrures tels que GaN, GaAlN, AIN, InN, constituent actuellement la famille de semi-conducteurs la plus prometteuse pour la réalisation de sources de lumières solides dans le visible et l'UV.

Des DELs hautes puissances [1, 2], et même des lasers courtes longueurs d'ondes [3, 4], ont été réalisés avec ces semi-conducteurs à base de nitrures.

La fabrication de ces composants est possible avec la famille des semi-conducteurs nitrures car le dopage p du GaN et du GaInN a pu être réalisé au début des années 1990 en utilisant du magnésium comme dopant [5].

Cependant, un problème qui continue à se poser avec les semi-conducteurs nitrures, qui persiste depuis les années 1990, et qui devient de plus en plus problématique quand on va vers les courtes longueurs d'ondes d'émission, est la forte résistivité du GaN et du AlGaN.

En effet, l'énergie d'activation du magnésium, le dopant le plus utilisé dans le GaN de type p est de 200 meV [6], ce qui représente plusieurs fois l'énergie thermique *kBT* à température ambiante (*kB* est la constante de Boltzmann et T la température). L'énergie d'activation des accepteurs augmente avec l'énergie de la bande interdite des semi-conducteurs, pour atteindre 630 meV dans le cas de AIN [3]. Ainsi, l'activation de trous est très peu efficace à température ambiante pour GaN, et est encore plus difficile pour AlGaN et AIN.

Les matériaux à base de ZnO sont une autre famille intéressante pour l'émission dans l'Ultraviolet et l'Ultraviolet profond à l'état solide.

Le ZnO a une énergie de bande interdite de 3,37 eV à la température ambiante, une grande énergie de liaison excitonique de 60 meV, ainsi qu'une forte probabilité de transitions excitoniques efficaces à températures élevées [7,8].

Comparé à AlGaInN, ZnO est donc un autre matériau à fort potentiel pour l'émission dans l'ultraviolet en raison de sa résistance aux rayonnements à haute énergie, de la disponibilité de substrats de haute qualité (conduisant à des géométries simples de DELs), et de la possibilité d'utiliser la gravure chimique humide pour former des mésas si d'autres substrats sont employés.

En outre, en réalisant des alliages avec le MgO, les composés ZnMgO peuvent être formés avec des énergies de bande interdite plus grandes, mais la quantité de Mg incorporé est limitée en pratique du fait de phénomènes de séparation de phase [9, 10].

La principale difficulté lors de la fabrication d'un émetteur UV entièrement basé sur du ZnO reste l'absence d'un procédé fiable pour obtenir un dopage de type p du ZnO, ce qui est nécessaire pour la formation d'homojonctions p-n [11, 12, 13, 14].

Par exemple, TSUKAZAKI et *al.* ont étudié le ZnO dopé à l'azote et ont réalisé des homojonctions p-i-n sur (0 0 0 1) ScAlMgO₄ [15].

RYU et *al.* ont démontré l'électroluminescence (EL) d'hétérostructures (Zn,Be)O / ZnO dans lesquelles la couche de type p a été dopée par de l'arsenic [16].

LIM et *al.* ont préparé une couche de ZnO dopé au phosphore dans des homojonctions p-n sur saphir par pulvérisation radiofréquence [17].

JIAO et *al.* ont décrit la fabrication d'une jonction pn ZnO LED sur un substrat Al₂O₃ [18].

IP et *al.* ont montré un comportement redresseur dans la caractéristique I(V) d'une hétérojonction ZnO / ZnMgO, dans laquelle le ZnMgO de type p a été dopé au phosphore [19].

Pour surmonter les limites du dopage de type p dans le ZnO ou, plus généralement, dans un semi-conducteur grand gap de type n, des structures dans lesquelles on inverse la conductivité d'une zone dans le ZnO ou dans le semi-conducteur grand gap de type n ont été récemment proposées [20, 21].

Cette zone, dans le semi-conducteur grand gap de type n dans laquelle la conductivité a été ainsi inversée, est communément appelée zone d'inversion par exemple couche d'inversion.

La présence d'une couche d'inversion dans le semi-conducteur grand gap de type n crée un canal de trous mobiles accessibles. Il suffit alors d'injecter des trous dans ce canal pour faire circuler un courant dans les structures décrites dans les documents [20, 21].

Cette zone est créée à l'aide d'une grille.

Cette grille est constituée d'une couche en un matériau isolant d'une épaisseur généralement comprise entre 0,5 nm et une dizaine de nanomètres, et d'une couche conductrice.

Le matériau isolant est généralement choisi parmi les oxydes de métaux et les oxydes de métalloïdes, et l'on utilise alors le terme « oxyde de grille » pour le désigner.

La qualité de cette grille est primordiale pour pouvoir obtenir une inversion de la conductivité dans le matériau grand gap de type n.

Il faut en effet être capable d'appliquer une tension suffisante à la grille afin d'inverser le type de conductivité sans que la grille ne fuie.

Si la qualité du matériau isolant de la grille, par exemple la qualité de l'oxyde de grille n'est pas suffisante, alors la grille fuit, et on ne peut pas inverser de zone dans le semi-conducteur de type n tel que le ZnO.

Il a déjà été proposé d'utiliser des matériaux diélectriques avec une constante diélectrique élevée (matériaux « high-k »), tels que le HfO₂ ou le ZrO₂, afin de constituer la couche isolante dans une grille pour inverser une zone dans le ZnO [22, 23, 24, 25], dans des applications telles que la fabrication de transistors à effet de champ.

Cependant, ces documents ne décrivent ni le procédé de fabrication de ces couches isolantes, ni les épaisseurs nécessaires des matériaux diélectriques high-k, ni la nature de la couche conductrice à utiliser pour obtenir une grille de bonne qualité.

Le document [26] décrit le dépôt de couches minces de HfO₂ d'une épaisseur de 4 nm sur des substrats « Silicium sur Isolant » (« Silicon On Insulator » ou « SOI » en anglais) par un procédé de dépôt de couche atomique (« *Atomic Layer Deposition* », ou « *ALD* » en anglais).

Des structures de grille ont été obtenues en utilisant un dépôt de HfO₂ et ZrO₂ par « Atomic Layer Deposition » (ALD) sur ZnO.

Ce procédé de dépôt a lieu dans une enceinte dans laquelle un vide inférieur à 100 Torr est réalisé. Un dispositif de régulation de la température permet de maintenir la température de l'échantillon pendant le dépôt, entre la température ambiante et au moins 500°C. Ce procédé consiste à envoyer alternativement des précurseurs de hafnium ou de zirconium tels que le tetrakis (dimethylamido) hafnium IV pour le Hafnium, et le tetrakis (dimethylamido) zirconium IV pour le zirconium, et de l'eau sur le substrat de ZnO, maintenu à une certaine température.

De cette manière, des couches conformes de HfO₂ et ZrO₂ peuvent être obtenues ([26] et [27]).

Il ressort de ce qui précède que l'obtention d'une zone d'inversion dans le semi-conducteur de type n, tel qu'un oxyde métallique semi-conducteur de type n, constitue une condition *sine qua none* pour faire fonctionner des dispositifs tels que décrits dans les documents [20, 21]. C'est pourquoi une attention toute particulière doit être portée au procédé de préparation de structures de type Matériau électriquement conducteur -Matériau électriquement isolant- Semi-conducteur, notamment de structures Métal-Isolant-Semi-conducteur ou « MIS », qui permettent d'obtenir une telle inversion.

Or, il n'existe à l'heure actuelle, aucun procédé de dépôt d'un matériau électriquement isolant, tel qu'un oxyde électriquement isolant comme HfO₂ ou ZrO₂, sur un substrat semi-conducteur tel qu'un substrat en oxyde métallique comme ZnO, CdO, MgO, ZnMgO, ou ZnCdO de type n, qui permette, après dépôt d'un matériau électriquement conducteur sur ce matériau électriquement isolant, d'obtenir une grille permettant d'inverser de manière efficace, fiable et reproductible, la conductivité d'une zone dans le substrat semi-conducteur.

Il existe donc un besoin pour un tel procédé.

Il existe encore un besoin pour un tel procédé qui assure que la grille ne fuit pas, c'est-à-dire qu'elle ne laisse pas passer de courant quand on lui applique une tension, et ce pour des tensions les plus élevées possible.

Typiquement, la couche en un matériau électriquement isolant, tel qu'un oxyde électriquement isolant (« oxyde de grille ») doit rester un bon isolant électrique pour des tensions d'au moins 10V. De cette manière, un champ électrique suffisamment important peut être obtenu dans le substrat semi-conducteur, de manière à y inverser la conductivité.

Le but de la présente invention est de fournir un procédé de fabrication d'une structure comprenant un substrat en un oxyde métallique semi-conducteur de type n, une première face du substrat étant revêtue d'une couche en un matériau électriquement isolant, et la couche en un matériau électriquement isolant étant revêtue d'au moins une couche en un matériau électriquement conducteur, qui réponde entre autres aux besoins énumérés plus haut.

### EXPOSÉ DE L'INVENTION

Ce but, et d'autres encore, sont atteints, conformément à l'invention par un procédé de fabrication d'une structure comprenant un substrat en un oxyde d'au moins un métal, semi-conducteur de type n, choisi parmi ZnO, CdO, MgO, ZnMgO, et ZnCdO, ledit substrat comprenant une première surface principale et une seconde surface principale, la première surface principale du substrat étant revêtue d'une couche en un matériau électriquement isolant, et la couche en un matériau électriquement isolant étant revêtue d'au moins une couche en un matériau électriquement conducteur, dans lequel on réalise les étapes successives suivantes :
a) on fournit un substrat en un oxyde d'au moins un métal semi-conducteur, de type n, choisi parmi ZnO, CdO, MgO, ZnMgO, et ZnCdO, dont le taux de dopage est inférieur ou égal à 10¹⁸/cm³;
b) on dépose sur la première surface principale du substrat, une couche d'une épaisseur de 1 à 10 nm, en un oxyde de métal ou de métalloïde électriquement isolant, ayant une constante diélectrique au moins égale à 4, de préférence au moins égale à 6, de préférence encore au moins égale à 7, mieux au moins égale à 25;
c) on effectue un recuit de la couche en un oxyde de métal ou de métalloïde électriquement isolant, sous une atmosphère d'oxygène ;
d) on dépose au moins une couche en un matériau électriquement conducteur sur la couche en un oxyde de métal ou de métalloïde électriquement isolant.

Le procédé selon l'invention comprend une suite spécifique d'étapes spécifiques qui n'a jamais été décrite dans l'art antérieur.

Ainsi, selon l'invention, on utilise un substrat en un oxyde de type n, semi-conducteur, qui présente un taux de dopage spécifique, à savoir un taux de dopage de type n inférieur ou égal à 10¹⁸/cm³.

Ensuite lors de l'étape b), on dépose sur la première surface principale du substrat, une couche qui, selon l'invention, possède une épaisseur spécifique, à savoir une épaisseur de 1 à 10 nm. Cette couche est en un oxyde de métal ou de métalloïde électriquement isolant, et cet oxyde de métal ou de métalloïde électriquement isolant est un oxyde spécifique, défini par une valeur particulière de sa constante diélectrique, qui est, selon l'invention, au moins égale à 4, de préférence au moins égale à 6, de préférence encore au moins égale à 7, mieux au moins égale à 25.

Selon une caractéristique fondamentale du procédé selon l'invention, on effectue après le dépôt de la couche en un oxyde de métal ou de métalloïde électriquement isolant, une étape c) de recuit de cette couche sous une atmosphère spécifique qui est une atmosphère d'oxygène.

Une telle étape de recuit sous une telle atmosphère n'est ni décrite ni suggérée dans l'art antérieur.

Le procédé selon l'invention, qui comprend cette suite spécifique d'étapes spécifiques, répond aux besoins et exigences mentionnés plus haut et apporte une solution aux problèmes des procédés de l'art antérieur.

En particulier, le procédé selon l'invention permet d'obtenir une grille permettant d'inverser de manière efficace, fiable et reproductible, la conductivité d'une zone dans un substrat en un oxyde d'au moins un métal, semi-conducteur, de type n.

En outre, la grille obtenue par le procédé selon l'invention ne fuit pas, c'est-à-dire qu'elle ne laisse pas passer de courant quand on lui applique une tension, et ce pour des tensions de grille pouvant aller jusqu'à 30 V. Cependant, grâce au procédé selon l'invention, ces tensions de grille ne sont pas trop élevées et ne dépassent pas généralement 30 V.

Le procédé selon l'invention permet de réaliser facilement une inversion de la conductivité dans des matériaux grands gaps pour lesquels le dopage de type p n'est pas maîtrisé.

Le procédé selon l'invention permet de ne pas avoir à doper ces matériaux pour obtenir une conductivité de type p et de réaliser notamment des DELs en effectuant une simple inversion de la conductivité.

Avantageusement, le taux de dopage du substrat en oxyde d'au moins un métal, semi-conducteur, de type n est de 10¹³ à 10¹⁸/cm³.

Avantageusement, l'oxyde de métal ou de métalloïde électriquement isolant est choisi parmi HfO₂ et ZrO₂.

Avantageusement, le dépôt de la couche en un oxyde de métal ou de métalloïde électriquement isolant est effectué par une technique de dépôt de couche atomique « ALD ».

Avantageusement, le dépôt de la couche en un oxyde de métal ou de métalloïde électriquement isolant est réalisé dans une enceinte sous vide où règne une pression inférieure à 100 Torrs.

Avantageusement, la température du substrat, pendant le dépôt de la couche en un oxyde de métal ou de métalloïde électriquement isolant, est inférieure ou égale à 450°C, de préférence la température du substrat est de 50°C à 450°C.

Avantageusement, le recuit de la couche en un oxyde de métal ou de métalloïde électriquement isolant est réalisé pendant une durée supérieure ou égale à 10 secondes, de préférence de 10 secondes à 15 minutes.

Avantageusement, le recuit de la couche en un oxyde de métal ou de métalloïde électriquement isolant est effectué à une température supérieure ou égale à 80°C, de préférence de 80°C à 500°C.

De manière préférée, le recuit est effectué à une température de 350°C, pendant une durée de 5 minutes.

Avantageusement, le matériau électriquement conducteur est un métal.

De préférence, le métal est choisi parmi le titane le cuivre, le platine, et l'or.

Avantageusement, l'épaisseur de la couche en un matériau électriquement conducteur tel qu'un métal ou de chacune des couches, lorsque plusieurs couches sont déposées, est généralement de 0,5 à 300 nm, de préférence de 1 à 200 nm, par exemple de 3 nm.

Les faibles épaisseurs permettent d'avoir des contacts semi-transparent permettant de laisser sortir de 20 à 90% de la lumière.

Par exemple un contact constitué d'une couche de 3 nm de Ti et d'une couche de 3 nm d'or permet de réaliser des structures MIS tout en restant presque transparent (environ 10% de l'émission absorbés dans le visible).

De préférence lors de l'étape d), on dépose ainsi successivement une première couche d'accroche, par exemple en un premier métal tel que le titane, et une seconde couche de protection contre l'oxydation, par exemple en un second métal qui ne s'oxyde pas, tel que l'or. L'or permet au Ti de ne pas s'oxyder.

L'invention concerne, en outre, un procédé de fabrication d'un dispositif optoélectronique comprenant une étape au cours de laquelle on fabrique une structure comprenant un substrat en un oxyde d'au moins un métal semi-conducteur, de type n, choisi parmi ZnO, CdO, MgO, ZnMgO, et ZnCdO, ledit substrat comprenant une première surface principale et une seconde surface principale, la première surface principale du substrat étant revêtue d'une couche en un matériau électriquement isolant, et la couche en un matériau électriquement isolant étant revêtue d'au moins une couche en un matériau électriquement conducteur, par le procédé tel que décrit plus haut.

Un tel procédé de fabrication possède tous les avantages inhérents au procédé de fabrication de la structure qui ont été énumérés plus haut.

Ce dispositif optoélectronique peut être notamment une diode électroluminescente, ou un transistor à effet de champ (« MOSFET »).

L'invention a trait en particulier à un procédé de fabrication d'une diode électroluminescence dans lequel :
- on fabrique une structure comprenant un substrat en un oxyde d'au moins un métal semi-conducteur, de type n, choisi parmi ZnO, CdO, MgO, ZnMgO, et ZnCdO, ledit substrat comprenant une première surface principale et une seconde surface principale, la première surface principale du substrat étant revêtue d'une couche en un matériau électriquement isolant, et la couche en un matériau électriquement isolant étant revêtue d'au moins une couche en un matériau électriquement conducteur, par le procédé tel que décrit plus haut ; puis
- on forme un contact électrique sur la seconde surface principale du substrat ;
- on forme une connexion électrique avec la couche en un matériau électriquement conducteur ;
- on forme une connexion électrique avec la zone du substrat dont la conductivité est inversée en une conductivité de type p, lors de l'application d'une tension négative à la couche en un matériau électriquement conducteur.

Là-encore, ce procédé de fabrication d'une diode électroluminescente possède tous les avantages inhérents au procédé de fabrication de la structure qui ont été énumérés plus haut.

L'invention sera mieux comprise et d'autres avantages de celle-ci apparaîtront mieux à la lecture de la description détaillée qui va suivre donnée à titre illustratif et non limitatif et faite en référence aux dessins joints.

### BRÈVE DESCRIPTION DES DESSINS

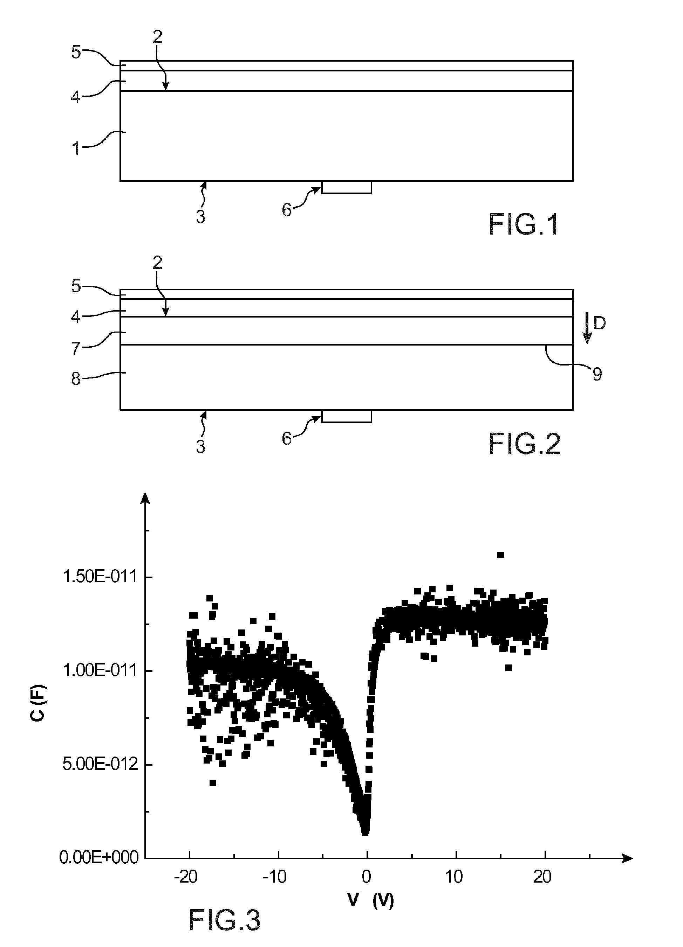

- La Figure 1 est une vue en coupe verticale schématique d'une structure de type « MIS » fabriquée par le procédé selon l'invention et qui permet de réaliser une inversion de la conductivité dans une partie d'un substrat en un oxyde d'au moins un métal, semi-conducteur, de type n, tel qu'un substrat en ZnO de type n.
- La Figure 2 est une vue en coupe verticale schématique qui illustre l'inversion de la conductivité obtenu dans une partie du substrat de type n de la structure de la Figure 1 suite à l'application d'une tension négative au dépôt métallique situé en haut de la structure de la Figure 1.
- La Figure 3 est un graphique qui montre la Courbe C(V) d'une structure selon l'invention (Exemple 2) constituée par une grille déposée sur un substrat en ZnO de type n. La grille consiste en un empilement d'une couche de 3nm de HfO₂, d'une couche de 5 nm de titane, et d'une couche de 5 nm d'or sur une face du substrat en ZnO. Après le dépôt du HfO₂, un recuit sous O₂ à 450°C pendant 1 min a été effectué. Un contact constitué d'une couche de 50 nm de Ti et d'une couche de 100 nm d'or a été réalisé sur l'autre face du substrat pour effectuer la mesure.

En ordonnée est porté C (en F) et en abscisse est porté V (en Volts).

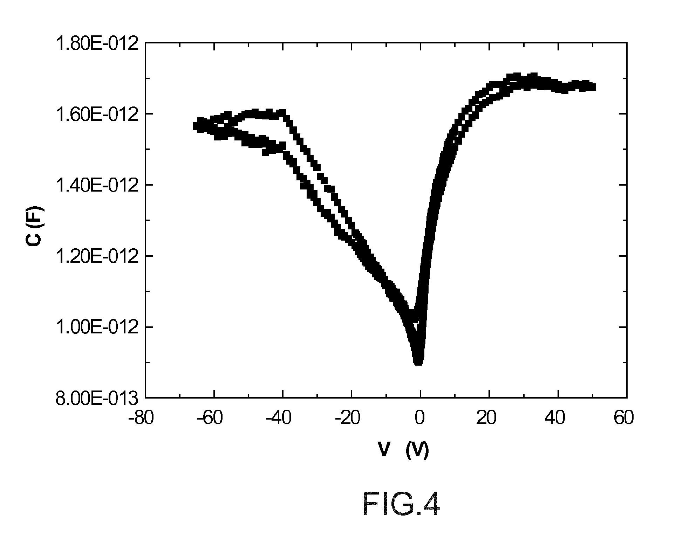

- La Figure 4 est un graphique qui montre la Courbe C(V) d'une structure selon l'invention (Exemple 3) constituée par une grille déposée sur un substrat en ZnO de type n. La grille consiste en un empilement d'une couche de 10 nm de HfO₂, d'une couche de 50 nm de titane, et d'une couche de 50 nm d'or sur une face du substrat en ZnO. Après le dépôt du HfO₂, un recuit sous O₂ à 450°C pendant 1 min a été effectué. Un contact constitué d'une couche de 50 nm de titane, et d'une couche de 100 nm d'or, a été réalisé sur l'autre face du substrat pour effectuer la mesure.

En ordonnée est porté C (en F) et en abscisse est porté V (en Volts).

### EXPOSÉ DÉTAILLÉ DE MODES DE RÉALISATION PARTICULIERS

Dans une première étape du procédé selon l'invention, on fournit un substrat (1) en un oxyde d'au moins un métal, ledit oxyde d'au moins un métal étant un semi-conducteur possédant une conductivité de type n.

Ledit oxyde d'au moins un métal peut être choisi parmi ZnO, CdO, MgO, ZnMgO, et ZnCdO.

On choisira de préférence ZnMgO pour une émission dans l'Ultraviolet et ZnCdO pour une émission dans le visible.

La description qui suit sera faite plutôt en référence à la fabrication d'une structure comprenant un substrat semi-conducteur (1) en ZnO, mais l'homme du métier pourra facilement adapter les enseignements qu'elle contient à la fabrication de structures comprenant des substrats semi-conducteurs en d'autres oxydes tels que CdO, MgO, ZnMgO, et ZnCdO.

Ce substrat (1) comprend une première surface principale (2) et une seconde surface principale (3).

Le substrat (1) est généralement un substrat plan, planaire, c'est-à-dire que les première (2) et seconde (3) surfaces mentionnées ci-dessus sont généralement planes, de préférence horizontales et parallèles et la première surface (2) est une surface supérieure, tandis que la seconde surface (3) est une surface inférieure.

Ces surfaces peuvent avoir par exemple la forme d'un polygone tel qu'un carré ou un rectangle, ou encore d'un cercle.

En outre, l'épaisseur du substrat (1) est généralement faible par rapport aux dimensions desdites première (2) et seconde (3) surfaces si bien que dans ce cas, on peut considérer que le substrat (1) se présente sous la forme d'une couche.

Le substrat (1) peut avoir une épaisseur de 10 nm à 1 mm, par exemple de 0,5 mm à 1 mm en fonction des applications.

Dans le cas d'épaisseurs faibles inférieures ou égales à 100 nm, par exemple de 10 nm à 100 nm, on parlera alors de couche mince. Le substrat (1) peut notamment avoir la forme d'un parallélépipède rectangle de l'épaisseur susmentionnée et dont les dimensions sont par exemple de 5 nm à 1 cm de longueur, et de 5 nm à 1 cm de largeur, ou encore la forme d'un substrat à section carrée de l'épaisseur susmentionnée et d'un côté de 5 nm à 1 cm.

De tels substrats en ZnO sont disponibles auprès de la société Crystec^{®} de Berlin, Allemagne, avec des tailles de 10 x 10 mm² ou de 10 x 5 mm², et des épaisseurs de 0,5 mm ou de 1 mm.

Conformément à l'invention, le ZnO possède une conductivité de type n et le taux de dopage de type n du ZnO, c'est-à-dire la concentration en donneurs intrinsèques, est inférieur ou égal à 10¹⁸/cm³.

En effet pour réussir à inverser une zone dans le ZnO, il ne faut pas qu'il y ait trop de charges à repousser dans celui-ci.

C'est la raison pour laquelle le taux de dopage de type n du ZnO qui constitue le substrat (1) est, selon l'invention, inférieur ou égal à 10¹⁸/cm³.

Cependant, pour que la structure puisse fonctionner dans un dispositif de DEL, tel que celui décrit dans le document [20], il est préférable que le dopage de type n du ZnO ne soit pas trop faible non plus. Par exemple, le taux de dopage de type n du substrat peut être supérieur ou égal à 10¹⁵/cm³.

De manière optimale, le taux de dopage de type n du ZnO est de 10¹⁵ à 10¹⁸/cm³.

On dépose ensuite sur la première surface principale (2) du substrat (1) une couche en un matériau électriquement isolant (4).

Selon l'invention, ce matériau électriquement isolant est un matériau isolant spécifique qui est choisi parmi les oxydes de métal ou de métalloïde.

Le choix spécifique d'un oxyde pour constituer la couche en un matériau électriquement isolant (4) va de pair avec l'étape ultérieure du procédé selon l'invention au cours de laquelle on effectue un recuit sous oxygène précisément pour améliorer la qualité de cet oxyde.

Fondamentalement, selon l'invention, le matériau électriquement isolant, choisi parmi les oxydes de métal ou de métalloïde électriquement isolants, a une « grande » constante diélectrique k, à savoir une constante diélectrique k au moins égale à 4, de préférence au moins égale à 6, de préférence encore au moins égale à 7, mieux au moins égale à 25.

En d'autres termes, il s'agit d'un oxyde « high k » de constante diélectrique supérieure ou égale à 4, de préférence supérieure ou égale à 6, de préférence encore supérieure ou égale à 7, mieux supérieure ou égale à 25.

En effet si la constante diélectrique de l'oxyde est trop faible, on ne parvient pas à inverser une zone dans le ZnO lorsque cet oxyde est utilisé comme oxyde de grille.

Ainsi, on a pu montrer que, lorsque l'on utilise du SiO₂, dont la constante diélectrique k est de seulement 3,4 en tant qu'oxyde de grille, on ne réussit pas à inverser une zone dans le ZnO.

Par contre, on a pu montrer que, lorsque l'on utilise du HfO₂ ou du ZrO₂, dont les constantes diélectriques k sont de l'ordre de 25 en tant qu'oxyde de grille, on réussit bien à inverser une zone dans le ZnO.

Il apparaît qu'une constante diélectrique k au moins égale à 25 pour l'oxyde de grille est optimale pour réaliser l'inversion d'une zone dans le ZnO.

En effet, pour des valeurs de la constante diélectrique inférieures à cette valeur optimale, les épaisseurs de grille devraient être très, trop, faibles, par exemple inférieures au nm, et les tensions de grille très fortes, par exemple supérieures à 30 V, pour obtenir un champ électrique suffisant dans le ZnO pour inverser une zone.

Le dépôt de la couche en un oxyde de métal ou de métalloïde électriquement isolant (4) est généralement effectué par une technique de dépôt de couche atomique « ALD ».

La température du substrat (1), pendant le dépôt de la couche en un oxyde de métal ou de métalloïde électriquement isolant tel que HfO₂ ou ZrO₂ doit généralement être inférieure à 450°C, pour que l'oxyde de métal ou de métalloïde électriquement isolant tel que HfO₂ ou ZrO₂ se dépose correctement.

Pour que le matériau conserve de bonnes propriétés diélectriques, la température ne doit généralement pas être trop faible non plus.

Typiquement des températures du substrat (1) entre 50°C et 450°C peuvent être utilisées, par exemple une température de 150°C.

Le dépôt par « ALD » s'effectue dans une enceinte dans laquelle règne un vide primaire ou un vide plus poussé, c'est-à-dire une enceinte dans laquelle règne une pression inférieure ou égale à 100 Torrs.

Un tel vide est nécessaire pour avoir un oxyde de métal ou de métalloïde électriquement isolant, tel que HfO₂ ou ZrO₂, de bonne qualité.

En particulier, un tel vide est important pour que les propriétés diélectriques, et notamment un fort coefficient diélectrique, ainsi que les propriétés de bon isolant électrique de l'oxyde de métal ou de métalloïde électriquement isolant soient obtenues.

Un cycle de dépôt de couche atomique « ALD » comprend généralement 4 étapes:
1) Exposition de la surface (c'est-à-dire de la première surface principale (2)) du substrat (1), préalablement chauffé à la température mentionnée plus haut, à un précurseur contenant le métal ou le métalloïde de l'oxyde de métal ou de métalloïde électriquement isolant.
   Si cet oxyde est un oxyde d'hafnium ou un oxyde de zirconium alors le précurseur contiendra respectivement de l'Hafnium ou du Zirconium.
   Ces précurseurs sont généralement des composés organométalliques de métal ou métalloïde.
   Un exemple de précurseur contenant de l'hafnium est le tetrakis(dimethylamido) hafnium IV, et un exemple de précurseur contenant du zirconium est le tetrakis(dimethylamido) zirconium IV.
   La durée de l'exposition de la surface du substrat au précurseur doit être suffisante pour saturer la surface du substrat avec le précurseur, par exemple avec le précurseur contenant du hafnium ou du zirconium.
2) Etape de mise sous vide. Lors de cette étape, le substrat est maintenu pendant une certaine durée sous vide, sans exposition de la surface du substrat au précurseur.
   Cette étape permet de laisser le temps aux molécules du précurseur en excès de se désorber de la surface du substrat et d'être évacuées par le pompage.
3) Exposition de la surface du substrat à de l'eau.
   Cette étape permet d'oxyder les molécules de précurseur pour former une monocouche ou une fraction de monocouche d'oxyde de métal ou de métalloïde électriquement isolant, par exemple de HfO₂, ou de ZrO₂.
4) Etape de mise sous vide. Lors de cette étape, le substrat et la monocouche d'oxyde sont maintenus pendant une certaine durée sous vide, sans exposition de la surface du substrat à de l'eau. Cette étape permet d'évacuer l'excès de molécules d'eau.

Ce cycle est généralement répété.

La pression résiduelle dans la chambre de dépôt entre deux expositions de la surface à des précurseurs ou à de l'eau, c'est-à-dire lors des étapes 2) et 4), est généralement inférieure ou égale à 100 Torr, typiquement cette pression résiduelle est de 10⁻³ à 100 Torrs.

La pression pendant les impulsions, « pulses » (c'est-à-dire pendant les étapes d'exposition au précurseur ou à de l'eau) doit remonter au moins de 10% (par rapport à ladite pression résiduelle) dans l'enceinte.

La durée des étapes d'exposition à un précurseur (étape 1)), ou à de l'eau (étape 2)), et des étapes de mise sous vide (étapes 3) et 4)) est généralement supérieure à 0,05 s.

Pour que le procédé de dépôt ne soit pas trop long, la durée des étapes d'exposition à un précurseur (étape 1)) ou à de l'eau (étape 2)) est de préférence de 0,05 s à 1s, par exemple de 0,1 s, et la durée des étapes de mise sous vide (étapes 3) et 4)) est de préférence de 0.5 à 5 s, par exemple de 2s.

On peut réaliser de 1 à 1000 cycles, par exemple 100 cycles.

Le nombre de cycles est choisi de façon à obtenir l'épaisseur souhaitée de la couche d'oxyde de métal ou de métalloïde électriquement isolant (4), par exemple de HfO₂, ou de ZrO₂.

L'épaisseur de la couche d'oxyde de métal ou de métalloïde électriquement isolant (4) déposée, par exemple de la couche de HfO₂, ou de ZrO₂, ainsi que le recuit de cette couche après dépôt, comme on le verra plus loin, sont très importants pour obtenir des grilles qui ne fuient pas.

L'épaisseur de la couche d'oxyde de métal ou de métalloïde électriquement isolant (oxyde de grille) (4) doit donc être optimisée.

Si l'épaisseur de cette couche (4) est trop faible, les courants de fuite augmentent, malgré le fait que l'on fasse un recuit.

On pourra quand même inverser une zone dans le substrat par exemple en ZnO, mais on perdra de l'énergie du fait de ces courants de fuite à travers la grille.

Si l'épaisseur de cette couche (4) est trop importante, il faudra des tensions de grille trop élevées pour inverser une zone dans le substrat, par exemple en ZnO.

Il a été mis en évidence que l'épaisseur de cette couche (4) devait généralement être de 1 nm à 10 nm.

En effet, au-delà de 10 nm les tensions de grille sont trop élevées (à savoir généralement supérieures à 30V) ; tandis qu'en-dessous de cette valeur, on ne parvient pas à limiter les courants de fuite.

Une valeur de 3 nm est particulièrement préférée et constitue un bon compromis.

En choisissant l'épaisseur de la couche d'oxyde de métal ou de métalloïde électriquement isolant (4) dans cette plage, on peut préparer une grille permettant d'obtenir une inversion dans un oxyde de métal de type n, tel que du ZnO dopé avec une concentration de donneurs intrinsèques inférieure à 10¹⁸ cm⁻³ (c'est ce que montrent les Figures 3 et 4).

Pour obtenir une couche d'oxyde de métal ou de métalloïde électriquement isolant (4) d'une épaisseur de 1 nm, on doit généralement réaliser 10 cycles, tandis que pour obtenir une couche d'oxyde de métal ou de métalloïde électriquement isolant (4) d'une épaisseur de 10 nm, on doit généralement réaliser 100 cycles.

Conformément à l'invention, on effectue ensuite un recuit de la couche déposée en un oxyde de métal ou de métalloïde électriquement isolant (4) tel que HfO₂ ou ZrO₂, sous une atmosphère d'oxygène.

Ce recuit est généralement effectué pendant une durée supérieure à 10s, et à une température supérieure à 80°C.

De préférence, le recuit est effectué pendant une durée de 10s à 15 minutes, et à une température de recuit de 80°C à 500°C.

Par exemple, le recuit peut être effectué à une température de 350°C, pendant une durée de 5 minutes.

Ce recuit permet de grandement améliorer les propriétés de l'oxyde de métal ou de métalloïde électriquement isolant, et en particulier ses propriétés de diélectrique à forte constante diélectrique, et ses propriétés d'isolant électrique.

En effet, le recuit sous oxygène semble combler des lacunes d'oxygène qui servaient de chemin préférentiel pour conduire le courant.

Selon l'invention, on dépose une ou plusieurs couches en un matériau électriquement conducteur (5) sur la couche en oxyde de métal ou de métalloïde électriquement isolant (4).

Le nombre total de couches en un matériau électriquement conducteur (5) déposé peut aller de 1 à 20.

De préférence, dans le cas où la structure doit être utilisée dans une diode électroluminescente, ce matériau électriquement conducteur est un matériau transparent à la lumière émise par la diode afin qu'il laisse passer cette lumière.

Généralement, ce matériau électriquement conducteur est un métal.

De préférence, le métal est choisi parmi le titane, le cuivre, le platine, et l'or.

Cette couche (ou ces couches) en un matériau électriquement conducteur (5) peut être déposée par tout procédé de dépôt adéquat. Ainsi, dans le cas où cette couche (5) est une couche en métal, tel que l'or, elle peut être déposée par pulvérisation cathodique.

L'épaisseur de la couche en un matériau électriquement conducteur (5), tel qu'un métal, ou de chacune des couches lorsque plusieurs couches sont déposées est généralement de 0,5 à 300 nm, de préférence 1 à 200 nm.

Dans une forme de réalisation, on dépose un empilement de deux couches métalliques sur la couche en oxyde de métal ou de métalloïde électriquement isolant (4), tel que ZrO₂ ou HfO₂ pour finaliser la structure grille.

La première couche de cet empilement, qui est déposée directement sur la couche en oxyde de métal ou de métalloïde électriquement isolant, tel que ZrO₂ ou HfO₂, sert de couche d'accroche, il peut s'agir d'une couche de titane, déposée par exemple par pulvérisation cathodique.

La deuxième couche est généralement une couche en un métal qui ne s'oxyde pas.

Le rôle de cette deuxième couche est donc plutôt de protéger la première couche métallique de l'empilement, par exemple en titane, contre l'oxydation.

La deuxième couche de cet empilement déposée sur la première couche peut être une couche d'or, déposée par exemple par pulvérisation cathodique

L'épaisseur de la première couche, par exemple en titane, et l'épaisseur de la deuxième couche, par exemple en or, de cet empilement, sont généralement supérieures à 0,5 nm, de préférence de 1 à 50 nm, par exemple 20 nm.

Lorsque l'on applique une tension négative à la grille ou plus exactement à la couche en un matériau électriquement conducteur (5) (par l'intermédiaire d'une connexion électrique (non représentée) avec la couche (5)), par rapport au potentiel du substrat (1) imposé par une électrode ou contact (6) formé sur la seconde surface principale (3) du substrat (1), il se produit (voir Figure 2), une inversion de la conductivité dans une première zone (7) du substrat de type n, adjacente à la couche en oxyde de métal ou de métalloïde électriquement isolant (4), depuis la première surface principale (2) du substrat (1) et jusqu'à une distance (D) dans le substrat (1) à partir de cette première surface principale (2). Cette première zone (7) devient donc une zone qui possède une conductivité de type p.

Une seconde zone (8) du substrat (1), plus éloignée de la couche en oxyde de métal ou de métalloïde électriquement isolant (4) et s'étendant depuis la distance (D) à partir de la première surface principale (2) jusqu'à la seconde surface principale (3) conserve sa conductivité initiale de type n.

Une « pseudo-jonction p/n » (9) est ainsi créée dans le substrat (1).

La tension négative appliquée à la grille est généralement inférieure à - 3V, notamment inférieure à - 10 V, de préférence de -3 à -10V, par rapport au potentiel du substrat (1) et ce potentiel imposé au substrat est généralement de 0V.

L'application d'une tension de -10 V à la grille permet l'obtention d'une région de conductivité de type p (7) sous la couche en oxyde de métal ou de métalloïde électriquement isolant (4) qui peut aller jusqu'à une distance D de 100 nm sous la première surface principale (2).

Il a été trouvé, par des mesures de capacité en fonction de la tension appliquée à un empilement, substrat en ZnO/Oxyde tel que HfO₂ ou ZrO₂ /métal, que le régime d'inversion dans ZnO pouvait être atteint pour des tensions supérieures à 3V, quand l'épaisseur de la couche de l'oxyde HfO₂ ou ZrO₂ est de 1 nm, pour des tensions supérieures à 10 V quand l'épaisseur de la couche de HfO₂ ou de ZrO₂ est de 3 nm, et pour des tensions supérieures à 40 V quand l'épaisseur de la couche de l'oxyde HfO₂ ou de ZrO₂ est de 10 nm (voir exemples 2 et 3).

Au travers de la structure grille décrite précédemment, à savoir constituée par un empilement substrat en ZnO/Oxyde tel que HfO₂ ou ZrO₂ /métal, des résistances surfaciques de 10⁹Ω/cm² pour une épaisseur d'oxyde de 1 nm, de 10¹¹Ω/cm² pour une épaisseur d'oxyde de 3 nm et 10¹⁵Ω/cm² pour une épaisseur d'oxyde de 10 nm ont été mesurées.

Ceci montre bien la bonne résistivité électrique des oxydes réalisés, ainsi que l'importance du recuit réalisé.

Avant recuit, quelle que soit l'épaisseur de l'oxyde utilisée, les résistances surfaciques étaient inférieures à 10⁶Ω/cm² et il était impossible d'obtenir des courbes C(V) telles que celles présentées dans les figures 3 et 4 (voir exemples 2 et 3), attestant de la possibilité d'inverser une zone dans le ZnO.

La structure selon l'invention peut être notamment utilisée pour fabriquer une diode électroluminescente.

Afin de fabriquer une telle diode électroluminescente,
- on fabrique tout d'abord une structure comprenant un substrat en un oxyde d'au moins un métal semi-conducteur, de type n, choisi parmi ZnO, CdO, MgO, ZnMgO, et ZnCdO, une première face du substrat étant revêtue d'une couche en un matériau électriquement isolant, et la couche en un matériau électriquement isolant étant revêtue d'au moins une couche en un matériau électriquement conducteur, par le procédé tel que décrit plus haut ; puis
- on forme un contact ou connexion électrique (6), sur la seconde surface principale du substrat (« contact n ») ;
- on forme une connexion électrique avec la couche en un matériau électriquement conducteur (5) ;
- on forme une connexion ou contact électrique (« contact p ») avec la zone du substrat dont la conductivité est inversée en une conductivité de type p, lors de l'application d'une tension négative à la couche en un matériau électriquement conducteur (5).

Lorsque l'on applique une tension négative à la grille, ou plutôt à la couche en un matériau électriquement conducteur (5), on crée comme cela a été décrit plus haut, une « pseudo-jonction p/n » (9) dans le substrat (1).

En faisant passer un courant dans la structure grâce au contact p et au contact n (le contact (6)), on peut injecter des trous dans la région (7) de type p et des électrons dans la région (8) de type n et obtenir de l'électroluminescence. L'allumage de la diode peut être contrôlé grâce à la tension appliquée à la grille.

Pour augmenter l'efficacité de recombinaison, des structures à puits quantique peuvent être utilisées. La profondeur de la région d'inversion peut être contrôlée par la tension de grille qui peut être ajustée de telle manière que le puits quantique se trouve au niveau de la jonction p/n, par exemple 5.

Le procédé selon l'invention de fabrication d'une structure et d'un dispositif tel qu'une DEL s'applique à de nombreux semi-conducteurs et permet notamment de réaliser de l'émission de lumière dans l'UV et l'UV profond.

De fortes densités lumineuses dans l'UV peuvent être obtenues, ce qui permet de fabriquer des écrans.

Le procédé selon l'invention peut être notamment utilisé pour fabriquer des DELs blanches.

Le procédé selon l'invention permet en particulier de fabriquer des sources émettant dans l'UV profond, efficaces vers 200 nm pour faire de la désinfection de l'eau par irradiation UV.

L'invention va maintenant être décrite en référence aux exemples suivants, donnés à titre illustratif et non limitatif.

### EXEMPLES :

### Exemple 1.

Dans cet exemple, on fabrique une structure « MIS », plus exactement « MOS » par le procédé selon l'invention.

Au cours de ce procédé, on réalise notamment le dépôt, par une technique de dépôt de couche atomique (« *Atomic Layer Deposition* » ou « *ALS* »), de HfO₂ ou de ZrO₂ sur un substrat commercial en ZnO fourni par la société Crystec^{®} (de dimensions 1cm x 1 cm x 0,5 cm).

Une machine Savannah S100^{®} de chez Cambridge Nanotech^{®} est utilisée.

Le mode opératoire utilisé est le suivant :
- Régler les débitmètres d'azote pour que la pression de base dans l'enceinte sous vide de la machine entre deux impulsions, « pulses » (c'est à dire deux expositions à un précurseur ou a de l'eau) soit de l'ordre de 1 Torr, tandis que la pression lors des impulsions, « pulses » est de l'ordre de 1,2 Torr. Chauffer le substrat en ZnO à 150°C dans l'enceinte.

Choisir une durée d'impulsion de 0,1 s pour le précurseur contenant de l'Hafnium, à savoir le tetrakis(dimethylamido) hafnium IV ou le précurseur contenant du Zirconium , à savoir le tetrakis(dimethylamido) zirconium IV, ainsi que pour l'eau.
- Laisser un intervalle de temps de 2 s entre chaque impulsion.
- Réaliser 100 cycles pour obtenir une épaisseur de l'ordre de 10 nm. Cette épaisseur peut être ajustée en adaptant le nombre de cycles.
- Effectuer un recuit sous O₂ à 350°C pendant 5 minutes.
- Déposer 20 nm de titane et 20 nm d'or par pulvérisation cathodique.

### Exemple 2.

Dans cet exemple, on fabrique une structure « MIS », plus exactement « MOS » par le procédé selon l'invention.

Cette structure est constituée d'une grille déposée sur un substrat de ZnO (dopé à raison de 10¹⁸ at/cm³). La grille consiste en un empilement sur le ZnO d'une couche de HfO₂ d'une épaisseur de 3 nm, d'une couche de titane d'une épaisseur de 5 nm, et d'une couche d'or d'une épaisseur de 5 nm.

La couche de HfO₂ est déposée par une technique de dépôt de couche atomique (« *Atomic Layer Deposition* » ou « *ALD* »), dans des conditions analogues à celles décrites dans l'exemple 1, le nombre de cycles (30) étant ajusté pour obtenir l'épaisseur de HfO₂ voulue, à savoir 3 nm.

Les couches de titane et d'or sont déposées par pulvérisation cathodique.

Après le dépôt de la couche de HfO₂, on effectue un recuit sous oxygène à une température de 450°C pendant une minute.

Enfin, une couche de titane d'une épaisseur de 50 nm, et une couche d'or d'une épaisseur de 100 nm sont déposées sur l'autre face du substrat (opposée à la couche de HfO₂) pour former ainsi un contact afin de réaliser des mesures de capacité en fonction de la tension.

Les résultats des mesures ont été portés sur la Figure 3.

Dans cette configuration, le régime d'inversion est obtenu quand une tension négative est appliquée à la grille et est montré par le fait que la capacité mesurée pour les tensions négatives remonte à des valeurs équivalentes à celles trouvées pour des tensions fortement positives.

On constate que des tensions de 10 V doivent être appliquées pour atteindre le régime d'inversion.

Au travers de la structure grille de cet exemple, des résistances surfaciques de 10¹¹Ω/cm² pour une épaisseur d'oxyde de 3 nm, ont été mesurées.

Ceci montre bien la bonne résistivité électrique de l'oxyde réalisé, ainsi que l'importance du recuit réalisé.

### Exemple 3.

Dans cet exemple, on fabrique une structure « MIS », plus exactement « MOS » par le procédé selon l'invention.

Cette structure est constituée d'une grille déposée sur un substrat de ZnO (dopé à raison de 10¹⁸ at/cm³). La grille consiste en un empilement sur le ZnO d'une couche de HfO₂ d'une épaisseur de 10 nm, d'une couche de titane d'une épaisseur de 50 nm, et d'une couche d'or d'une épaisseur de 50 nm.

La couche de HfO₂ est déposée par une technique de dépôt de couche atomique (« *Atomic Layer Deposition* » ou « *ALD* »), dans des conditions analogues à celles décrites dans l'exemple 1, le nombre de cycles (100) étant ajusté pour obtenir l'épaisseur de HfO₂ voulue, à savoir 3 nm.

Les couches de titane et d'or sont déposées par pulvérisation cathodique.

Après le dépôt de la couche de HfO₂, on effectue un recuit sous oxygène à une température de 450°C pendant une minute.

Enfin, une couche de titane d'une épaisseur de 50 nm, et une couche d'or d'une épaisseur de 100 nm sont déposées sur l'autre face du substrat (opposé à la couche de HfO₂) pour former ainsi un contact afin de réaliser des mesures de capacité en fonction de la tension.

Les résultats des mesures ont été portés sur la Figure 4.

Dans cette configuration, le régime d'inversion est obtenu quand une tension négative est appliquée à la grille et est montré par le fait que la capacité mesurée pour les tensions négatives remonte à des valeurs équivalentes à celles trouvées pour des tensions fortement positives. On constate que des tensions de 40 V doivent être appliquées pour atteindre le régime d'inversion.

Au travers de la structure grille de cet exemple, des résistances surfaciques de 10¹⁵Ω/cm² pour une épaisseur d'oxyde de 10 nm, ont été mesurées.

Ceci montre bien la bonne résistivité électrique de l'oxyde réalisé, ainsi que l'importance du recuit réalisé.

Avant recuit, quelle que soit l'épaisseur de l'oxyde utilisée, les résistances surfaciques étaient inférieures à 10⁶Ω/cm² et il était impossible d'obtenir des courbes C(V) telles que celles présentées dans les Figures 3 et 4 attestant de la possibilité d'inverser une zone dans le ZnO.

### REFERENCES

[1] D. A. Steigerwald et al., IEEEJ. Sel. Top. Quantum Electron. 8, 310 (2002).
[2] O. Brandt et al., Nat. Mater. 5, 769 (2006).
[3] Y. Taniyasu et al., Nature 441, 325 (2006).
[4] A. Khan et al., Nat. Photonics 2, 77 (2008).
[5] S. Nakamura et al., Jpn. J. Appl. Phys. 31, 1258 (1992).
[6] P. Kozodoy et al., J. Appl. Phys. 87, 1832 (2000).
[7] D. C. Look, «Doping and defects in ZnO bulk » dans Thin Films and Nanostructures, C. Jagadish and S. J. Pearton, Eds. Oxford, U.K.: Elsevier, 2006.
[8] D. P. Norton et al., Mater. Today 7, 34 (2006).
[9] S. Choopun et al., Appl. Phys. Lett. 80, 1529 (2002).
[10] W. Yang et al., Appl. Phys. Lett. 78, 2787 (2001).
[11] D. C. Look et al., Appl. Phys. Lett. 85, 5269 (2004).
[12] A. Ashrafi et al., Jpn. J. Appl. Phys. 41, L1281 (2002).
[13] A. V. Singh et al., J. Appl. Phys. 93, 396 (2003).
[14] T. M. Barnes et al., Appl. Phys. Lett. 86, 112 (2005).
[15] A. Tsukazaki et al., Nat. Mater. 4, 42 (2005).
[16] Y. R. Ryu et al., Appl. Phys. Lett. 88, 241 (2006).
[17] J. H. Lim et al., Adv. Mater. 18, 2720 (2006).
[18] S. J. Jiao et al., Appl. Phys. Lett. 88, 031911 (2006).
[19] K. Ip et al., Appl. Phys. Lett. 85, 1169 (2004).
[20] EP-A1-2 149 919 & US-A1-2010/0025654
[21] WO-A1-2009/128777
[22] US-A1-2001/0006346
[23] US-A1-2008/0128760
[24] WO-A2-2006/105077
[25] WO-A2-2006/051995
[26] D. Gu, K. Tapily, P. Shrestha, M. Y. Zhu, G. Celler, et H. Baumgart, Journal of The Electrochemical Society, 155 G129-G133 (2008).
[27] Diefeng Gu, Helmut Baumgart, Gon Namkoong, et Tarek M. Abdel-Fattah, Electrochemical and Solid-State Letters, 12 K25-K28 (2009).

## Revendications

1. Procédé de fabrication d'une structure comprenant un substrat en un oxyde d'au moins un métal, semi-conducteur de type n, choisi parmi ZnO, CdO, MgO, ZnMgO, et ZnCdO, ledit substrat comprenant une première surface principale et une seconde surface principale, la première surface principale du substrat étant revêtue d'une couche en un matériau électriquement isolant, et la couche en un matériau électriquement isolant étant revêtue d'au moins une couche en un matériau électriquement conducteur, dans lequel on réalise les étapes successives suivantes :
a) on fournit un substrat en un oxyde d'au moins un métal semi-conducteur, de type n, choisi parmi ZnO, CdO, MgO, ZnMgO, et ZnCdO, dont le taux de dopage est inférieur ou égal à 10¹⁸/cm³;
b) on dépose sur la première surface principale du substrat, une couche d'une épaisseur de 1 à 10 nm, en un oxyde de métal ou de métalloïde électriquement isolant, ayant une constante diélectrique au moins égale à 4, de préférence au moins égale à 6, de préférence encore au moins égale à 7, mieux au moins égale à 25 ;
c) on effectue un recuit de la couche en un oxyde de métal ou de métalloïde électriquement isolant, sous une atmosphère d'oxygène ;
d) on dépose au moins une couche en un matériau électriquement conducteur sur la couche en un oxyde de métal ou de métalloïde électriquement isolant.

2. Procédé selon la revendication 1, dans lequel le taux de dopage du substrat en oxyde d'au moins un métal, semi-conducteur, de type n est de 10¹³ à 10¹⁸/cm³.

3. Procédé selon la revendication 1 ou 2, dans lequel l'oxyde de métal ou de métalloïde électriquement isolant est choisi parmi HfO₂ et ZrO₂.

4. Procédé selon l'une quelconque des revendications précédentes, dans lequel le dépôt de la couche en un oxyde de métal ou de métalloïde électriquement isolant est effectué par une technique de dépôt de couche atomique ALD.

5. Procédé selon la revendication 4, dans lequel le dépôt de la couche en un oxyde de métal ou de métalloïde électriquement isolant est réalisé dans une enceinte sous vide où règne une pression inférieure à 100 Torrs.

6. Procédé selon l'une quelconque des revendications 4 et 5, dans lequel la température du substrat, pendant le dépôt de la couche en un oxyde de métal ou de métalloïde électriquement isolant, est inférieure ou égale à 450°C, de préférence la température du substrat est de 50°C à 450°C.

7. Procédé selon l'une quelconque des revendications précédentes, dans lequel le recuit de la couche en un oxyde de métal ou de métalloïde électriquement isolant, est réalisé pendant une durée supérieure ou égale à 10 secondes, de préférence de 10 secondes à 15 minutes.

8. Procédé selon l'une quelconque des revendications précédentes, dans lequel le recuit de la couche en un oxyde de métal ou de métalloïde électriquement isolant est effectué à une température supérieure ou égale à 80°C, de préférence de 80°C à 500°C.

9. Procédé selon l'une quelconque des revendications 7 et 8, dans lequel le recuit est effectué à une température de 350°C, pendant une durée de 5 minutes.

10. Procédé selon l'une quelconque des revendications précédentes, dans lequel l'épaisseur de la couche en un matériau électriquement conducteur, ou de chacune des couches, lorsque plusieurs couches sont déposées, est de 0,5 à 300 nm .

11. Procédé selon l'une quelconque des revendications précédentes, dans lequel le matériau électriquement conducteur est un métal.

12. Procédé selon la revendication 11, dans lequel le métal est choisi parmi le titane, le cuivre, le platine, et l'or.

13. Procédé selon l'une quelconque des revendications précédentes, dans lequel, lors de l'étape d), on dépose successivement une première couche d'accroche, par exemple en un premier métal tel que le titane, et une seconde couche de protection contre l'oxydation, par exemple en un second métal qui ne s'oxyde pas tel que l'or.

14. Procédé de fabrication d'un dispositif opto-électronique comprenant une étape au cours de laquelle on fabrique une structure comprenant un substrat en un oxyde d'au moins un métal semi-conducteur, de type n, choisi parmi ZnO, CdO, MgO, ZnMgO, et ZnCdO, ledit substrat comprenant une première surface principale et une seconde surface principale, la première surface principale du substrat étant revêtue d'une couche en un matériau électriquement isolant, et la couche en un matériau électriquement isolant étant revêtue d'au moins une couche en un matériau électriquement conducteur, par le procédé selon l'une quelconque des revendications 1 à 13.

15. Procédé selon la revendication 14, dans lequel ledit dispositif est une diode électroluminescente ou un transistor à effet de champ (« MOSFET »).

16. Procédé de fabrication d'une diode électroluminescence dans lequel :
- on fabrique une structure comprenant un substrat en un oxyde d'au moins un métal semi-conducteur, de type n, choisi parmi ZnO, CdO, MgO, ZnMgO, et ZnCdO, ledit substrat comprenant une première surface principale et une seconde surface principale, la première surface principale du substrat étant revêtue d'une couche en un matériau électriquement isolant, et la couche en un matériau électriquement isolant étant revêtue d'au moins une couche en un matériau électriquement conducteur, par le procédé selon l'une quelconque des revendications 1 à 13 ; puis
- on forme un contact électrique sur la seconde surface principale du substrat ;
- on forme une connexion électrique avec la couche en un matériau électriquement conducteur ;
- on forme une connexion électrique avec la zone du substrat dont la conductivité est inversée en une conductivité de type p, lors de l'application d'une tension négative à la couche en un matériau électriquement conducteur.
